Europäisches Patentamt

European Patent Office

Office européen des brevets

(11) Publication number: **0 072 643**
**B1**

# EUROPEAN PATENT SPECIFICATION

(45) Date of publication of patent specification: **03.02.88**

(51) Int. Cl.⁴: **C 23 C 4/10, C 23 C 4/12**

(21) Application number: **82304057.1**

(22) Date of filing: **02.08.82**

(54) Cordierite powders and protective coatings formed therefrom.

(30) Priority: **19.08.81 US 294250**

(43) Date of publication of application:
**23.02.83 Bulletin 83/08**

(45) Publication of the grant of the patent:
**03.02.88 Bulletin 88/05**

(84) Designated Contracting States:
**AT BE CH DE FR GB IT LI NL SE**

(56) References cited:
**BE-A- 767 344**
**CH-A- 312 548**
**FR-A-2 259 917**
**US-A-3 036 929**
**US-A-4 159 353**

**CHEMICAL ABSTRACTS, vol. 84, 1976, page 282, no. 154645k, Columbus, Ohio, US**

(73) Proprietor: **UNICORN INDUSTRIES LIMITED**
**285 Long Acre**
**Birmingham B7 5JR (GB)**

(72) Inventor: **Iseli, Robert W.**
**1919 Beechwood Drive**
**Florence Alabama (US)**
Inventor: **Herman, Herbert**
**11 Meroke Trail**
**Port Jefferson New York (US)**

(74) Representative: **Shaw, Laurence**
**George House George Road**
**Edgbaston Birmingham B15 1PG (GB)**

Courier Press, Leamington Spa, England.

**Description**

It is well known that components in many industries are subject to extreme conditions. Parts are often protected from severe thermal and mechanical conditions by protective coatings. In gas turbine engines, for example, the wall of the shroud frequently comes in contact with the rotating turbine blade. It is desirable to form a seal between the blade and the shroud to restrict gas leakage and permit higher operating gas pressures and temperatures. The shroud wall is subject to severe wear in the form of rubbing, erosion and high temperatures and it must therefore be protected while at the same time allowing the cutting action of the blade tip to make the mechanical seal. If the seal is not properly abradable or of sufficient thickness, the seal will be lost and/or the blades may be damaged, risking engine failure. Currently, metal-polymer composites are flame sprayed on shrouds to furnish a suitable seal. The resulting porous metal (the polymer is thought to be burned out during the spraying process) gives a low temperature seal. Metal-graphite has been used as well.

It is known from CH—A—312548 to apply to a component a protective coating of cordierite. It is also known from US—A—4159353 to form an adherent platinum coating on refractories by plasma flame spraying an intermediate layer of a refractory oxide e.g. cordierite and then spraying thereon platinum powder.

According to the invention there is provided a method of applying a protective coating to the surface of a component, e.g. the shroud wall of a gas turbine engine, to protect the surface against thermomechanical damage, the method comprising applying a coating of cordierite to the metal surface characterised in that the cordierite applied is a powder which has been subjected to the preliminary step of fusing or melting so as to remove low temperature phases and give the cordierite a uniform melting temperature, and in that the substantially pure cordierite is then reduced to a powder which is applied by thermal spraying to form the protective coating on the surface of the metal component.

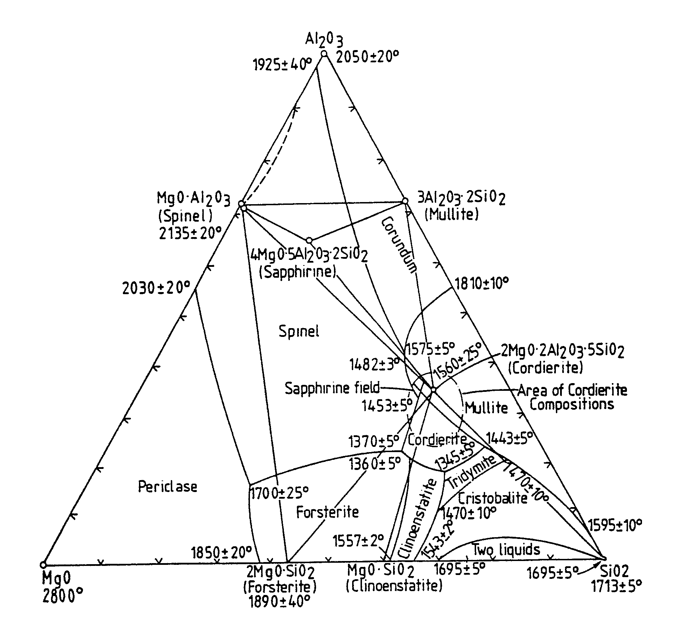

The substantially pure cordierite powder is preferably selected from a cordierite composition in the circled area of the phase diagram of the accompanying drawing. Preferably the cordierite is a member of the cordierite-mullite family and has a typical composition as follows:

$$(2MgO . 2Al_2O_3 . 5SiO_2)$$

| | |
|---|---|
| MgO | 13.7% wt. |
| $Al_2O_3$ | 34.9% wt. |
| $SiO_2$ | 51.4% wt. |

The melting temperature for the eutectic cordierite is 1470°±5°C.

It is a feature of this invention that the cordierite be substantially pure so that it has a uniform melting temperature and that all particles of the material have the same composition. According to the invention a cordierite forming mixture is made substantially pure by being melted or fused before the material is subjected to the thermal spray application. This fusing has the effect of removing low temperature phases which would otherwise mar or harm the properties of the coating to be formed. The material may be fused using standard ceramic techniques. As a result of the fusing, the cordierite used in this invention is substantially pure, often 99% or more pure cordierite.

The cordierite may be formed in a variety of known ways using a mixture of materials such as: (i) clay, kyanite, pyrophillite, quartz, or silica; (ii) talc or the like; and (iii) alumina or aluminium hydroxide. Appropriate techniques for making our compositions from the foregoing raw materials will be apparent to those skilled in the relevant arts from, for example, US Patent No. 3,950,175 issued April 17, 1976, to Lachman et al which is hereby incorporated herein by reference. Synthetic cordierite is known and may be used in the invention: see e.g. U.S. Patent 3,979,216 in which the material has a low open porosity.

Additives such as yttria or yttrium, hafnium and other rare earths or their oxides may be added to the composition before it is fused to improve the corrosion resistance, strength and other properties of the coating. Typically, a rare earth additive such as yttrium will be added in amounts up to 4% preferably up to 2% or 0.5% of the composition by weight. Mixtures of rare earths with refractory oxides such as zirconia can be used. A mixture may be yttria and zirconia, preferably 4:6 parts; about 10% by weight of this additive may be employed.

An additional important and distinguishing feature of the fused substantially pure powder is its high exothermicity. This associated with recrystallisation, the threshold temperature of which appears to be in excess of 850°C and which will occur during thermal spraying and on the heating of the thus formed coating. This exothermic reaction is unique in thermal spray applied oxide ceramics and is important because it enhances cohesion and adhesive bond strengths.

The substantially pure cordierite powder may be applied using any suitable thermal spray gun. Examples include combustion and plasma guns manufactured and/or marketed in the United States of America by Dresser Industries, Plasmadyne, Plasmatechnic, Metco, Electroplasma, and Castolin-Eutectic Corporations.

The substantially pure cordierite may be applied at about 1.5 kg per hour. Higher rates may be used depending upon the equipment and application. The spraying parameters are determined by the exact composition, particle size and retention time.

**0 072 643**

A much preferred advantage of this invention is that it is not usually necessary to precoat the substrate in many applications, although precoating may be done to improve its application for extremely corrosive environments.

The thickness of the coating may exceed 2 mm without loss of adhesion strength. The coating displays an excellent interface, giving good adhesion to the substrate.

The coating is characterised by outstanding thermal shock resistance and excellent thermal barrier properties. The coating has a controllable porosity range of up to 40 volume percent, which is an unusually high level, in that other materials do not provide reliable porosities much in excess of 25 volume percent. Porosity is calculated with reference to the relationship of the bulk density to the apparent solid density or to the true density. Porosity is important for abradability and thermal conductivity. The porosity of the coating material can be varied in several ways; e.g. by varying the spray rate and spray temperature. Also, porosity may be controlled, if a plasma arc gun is employed, by regulating the voltage across, and/or current between, the electrodes of the plasma arc gun. Porosity may also be controlled by varying the distance between the thermal spray gun and the target or component being coated. As the distance between the gun and the target is increased, the coating will become more porous.

Organic and inorganic additives may be included to fill some or all of the pores to modify the properties of the coating. For example, pore filling additives may be employed to keep corrosive material in the ambient environment from penetrating to the coated substrate or to keep cracks from developing in the coating. The pores may be filled with an appropriate lubricant such as Teflon®, molybdenum disulfide or graphite to improve lubricity in applications where the component functions as a bearing or is otherwise in moving contact with another component.

The machine component to which the coating is applied may be part of a rocket engine, an aircraft jet engine, an abradable seal, an aircraft carrier structural member, or any other application requiring a thermal barrier coating, vibration or sound absorbing property.

In order that the invention may be well understood it will now be described with reference to the following Example.

Example

Fused substantially pure cordierite was made by melting 13.7% MgO, 34.9% $Al_2O_3$ and 51.4% $SiO_2$ in a fusion furnace. The resulting solid was reduced to a −61 to +11 μm powder. The powder was sprayed at a rate of about 1.5 kg/hour through a Metco 3MB gun onto a steel substrate to a thickness in excess of 2 mm.

The coating thus formed was found to have the following properties:

|  |  |  |
|---|---|---|
|  | —Profile microhardness | —600—700 at 15 gram load |
| Superficial hardness | —Rockwell | —$R_B$ 70 |
| Metallograph | —Microscope | —Lamillar structure interlamillar porosity |
| Porosity | —By optical metallograph | —20%—40%; porosity; mainly discontinuous |
| Thermal test | —12 times .25 mm from nozzle of 35 KW argon-hydrogen plasma. Heated till substrate was red-white hot—then water quenched | —No spalling, peeling or cracking |
| Thickness | —Continuous overcoating | —2.5 mm (not the limit of thickness) |
| Bond test | —Substrate—10×10×2 mm | —No interfacial failure to angles greater than 90° (approximately 120°) |
| Crystallinity | —X-Ray powder diffraction methods | —As sprayed structure is amorphous; crystallisation temperature appears to be in excess of 850°C |

3

**Claims**

1. A method of applying a protective coating to the surface of a metal component, e.g. the shroud wall of a gas turbine engine, to protect the surface against thermomechanical damage, the method comprising applying a coating of cordierite to the metal surface characterised in that the cordierite applied is a powder which has been subjected to the preliminary step of fusing or melting so as to remove low temperature phases and give the cordierite a uniform melting temperature, and in that the substantially pure cordierite is then reduced to a powder which is applied by thermal spraying to form the protective coating on the surface of the metal component.

2. A method according to claim 1, characterised in that the coating is sprayed to a thickness of up to 2 mm.

3. A method according to claim 1 or 2 characterised in that the porosity of the coating is controlled by varying the rate and/or temperature at which the substantially pure cordierite powder is applied to the metal surface or by regulating the voltage across, and/or current flowing between, the electrodes of a plasma arc gun used to apply the powder.

4. A method according to any preceding claim, characterised in that the coating is formed with a porosity of up to about 40 percent.

5. A method according to any preceding claim characterised in that the cordierite is a member of the cordierite-mullite family.

6. A method according to any preceding claim characterised in that a pore filling organic or inorganic additive is present in the coating.

**Patentansprüche**

1. Verfahren zum Aufbringen eines Schutzüberzugs auf die Oberfläche eines Metallbauteils, z.B. der Gehäusewand eines Gasturbinentriebwerks, zu deren Schutz gegen thermomechanische Beschädigung, wobei ein Cordieritüberzug auf die Metalloberfläche aufgebracht wird, dadurch gekennzeichnet, dass der aufgebrachte Cordierit ein Pulver ist, das zuvor einem Verschmelzungs- oder Schmelzvorgang unterzogen wurde, um Tieftemperaturphasen zu entfernen und dem Cordierit einen einheitlichen Schmelzpunkt zu verleihen, und dass der weitgehend reine Cordierit dann zu einem Pulver zerkleinert wird, das durch thermisches Spritzen zur Bildung des Schutzüberzugs auf der Oberfläche des Metallbauteils aufgebracht wird.

2. Verfahren nach Anspruch 1, dadurch gekennzeichnet, dass der Überzug zu einer Dicke von bis zu 2 mm aufgespritzt wird.

3. Verfahren nach Anspruch 1 oder 2, dadurch gekennzeichnet, dass die Porosität des Überzugs durch Veränderung der Menge bzw. der Temperatur, bei der das weitgehend reine Cordieritpulver auf die Metalloberfläche aufgebracht wird, oder durch Regulierung der an die Elektroden eines zum Aufbringen des Pulvers verwendeten Plasmalichtbogenbrenners angelegten Spannung bzw. des zwischen diesen fliessenden Stromes gesteuert wird.

4. Verfahren nach einem der vorhergehenden Ansprüche, dadurch gekennzeichnet, dass der Überzug mit einer Porosität von bis zu etwa 40 Prozent gebildet wird.

5. Verfahren nach einem der vorhergehenden Ansprüche, dadurch gekennzeichnet, dass der Cordierit zur Cordierit-Mullitgruppe gehört.

6. Verfahren nach einem der vorhergehenden Ansprüche, dadurch gekennzeichnet, dass ein porenfüllender, organischer oder anorganischer Zusatzstoff im Überzug vorhanden ist.

**Revendications**

1. Un procédé d'application d'un revêtement protecteur sur la surface d'une pièce métallique, par exemple la paroi de protection d'un moteur à turbine à gaz, pour protéger la surface contre les dommages thermomécaniques, le procédé comprenant l'application d'un revêtement de cordiérite sur la surface métallique, caractérisé en ce que la cordiérite appliquée est une poudre qui a été soumise à l'étape préliminaire de frittage ou de fusion de façon à éliminer les phases de températures basses et à donner à la cordiérite une température de fusion uniforme et en ce que la cordiérite sensiblement pure est ensuite réduite en une poudre qui est appliquée par pulvérisation thermique pour former le revêtement protecteur sur la surface de la pièce métallique.

2. Un procédé selon la revendication 1, caractérisé en ce que le revêtement est pulvérisé pour donner une épaisseur pouvant aller jusqu'à 2 mm.

3. Un procédé selon la revendication 1 ou la revendication 2, caractérisé en ce que la porosité du revêtement est contrôlée en faisant varier le taux et/ou la température auxquels la poudre de cordiérite sensiblement pure est appliquée à la surface métallique ou en modulant la tension entre, et/ou le courant passant entre, les électrodes d'un pistolet à arc-plasma utilisé pour appliquer la poudre.

4. Un procédé selon l'une quelconque des revendications précédentes, caractérisé en ce que le revêtement est formé avec une porosité pouvant aller jusqu'à environ 40%.

5. Un procédé selon l'une quelconque des revendications précédentes, caractérisé en ce que la cordiérite est un membre de la famille cordiérite-mullite.

6. Un procédé selon l'une quelconque des revendications précédentes, caractérisé en ce qu'un additif organique ou minéral remplissant les pores est présent dans le revêtement.